# EUROPEAN PATENT APPLICATION

(11) **EP 4 679 118 A1**
(43) Date of publication of application: **14.01.2026**
(21) Application number: 25184996.4
(22) Date of filing: 24.06.2025
(51) Int. Cl.: G01R 33/00, H10N 50/01, H10N 59/00, G01R 33/07

(54) **METHOD OF PRODUCING A SEMICONDUCTOR SUBSTRATE WITH MAGNETIC FLUX CONCENTRATORS, AND A MAGNETIC SENSOR DEVICE**

(30) Priority: 01.07.2024 EP 24185786
(71) Applicant: Melexis Technologies SA, 2022 Bevaix (CH)
(72) Inventor: Op de Beeck, Jonathan, 3980 Tessenderlo (BE); VAN DER WIEL, Appo, 3980 Tessenderlo (BE)
(74) Representative: Jacobs, Lambert

(57) **Abstract**

Method (100; 200; 1100; 1700) for producing a semiconductor wafer having a front side (01) comprising at least one magnetic sensor element (M1), and a back side (03), and an interconnection stack (10) comprising at least one contact area (12); the method comprising the steps of: m) mounting (102) a carrier wafer (41) to the front side; b) thinning (103) the back side; c) providing at least one magnetic concentrator (31) to the front side; d) providing at least one magnetic concentrator (32) to the back side. A magnetic sensor device comprising a semiconductor substrate with a magnetic sensor element, a front IMC and a back IMC, located on opposite sides of the semiconductor substrate.

## Description

### Field of the invention

The present invention relates to the field of semiconductor devices comprising at least one magnetic sensor and at least one magnetic flux concentrator, and to methods of producing such devices.

### Background of the invention

Semiconductor devices (e.g. magnetic sensor devices) comprising a semiconductor substrate and at least one horizontal Hall element, and at least one integrated Magnetic Flux Concentrator (abbreviated herein as: IMFC or IMC) are known in the art, for example from US2002021124(A1), filed about 20 years ago. Examples of such devices are linear position sensor devices, angular position sensor devices, current sensor devices, etc.

Various solid state magnetic sensor elements are known in the art, e.g. horizontal Hall elements, vertical Hall elements, magneto-resistive elements (e.g. AMR, GMR, TMR, XMR elements). It is known that a horizontal Hall elements (without IMC on top) are sensitive to a magnetic field oriented perpendicular to a semiconductor substrate, and that vertical Hall elements and magneto-resistive (MR) elements are sensitive to a magnetic field oriented parallel to the semiconductor substrate.

It is known that a horizontal Hall element made in a compound semiconductor material selected from the III-V-group, for example Ga-As or In-As, has a much higher sensitivity than an equally large horizontal Hall element made in a Silicon or CMOS substrate.

There is always room for improvements or alternatives.

### Summary of the invention

It is an object of embodiments of the present invention to provide a method of producing a semiconductor substrate (e.g. a semiconductor wafer or a semiconductor die) comprising a magnetic sensor with an improved sensitivity.

It is an object of embodiments of the present invention to provide a method of producing a semiconductor substrate (e.g. a semiconductor wafer or a semiconductor die) comprising at least one magnetic sensor (e.g. a horizontal Hall element, a vertical Hall element, a magneto-resistive element) and at least two Magnetic Flux Concentrators (IMC).

It is an object of embodiments of the present invention to provide a method of producing a semiconductor substrate (e.g. a semiconductor wafer or a semiconductor die) comprising at least one magnetic sensor (e.g. a horizontal Hall element, a vertical Hall element, a magneto-resistive element) and comprising a biasing and readout circuit and/or a processing circuit, and comprising at least two magnetic flux concentrators (IMC), wherein the at least two IMC's are arranged at different height positions (measured along a Z-axis perpendicular to the semiconductor substrate), for example one IMC being arranged in a plane above the plane that contains the magnetic sensor(s) and another IMC being arranged in a plane below the plane that contains the magnetic sensor(s).

It is an object of embodiments of the present invention to provide a method of producing a semiconductor substrate (e.g. a semiconductor wafer or a semiconductor die) comprising a device layer comprising at least one magnetic sensor element (e.g. a horizontal Hall element, a vertical Hall element, a magneto-resistive element), and wherein the semiconductor substrate has a front side and a back side, and wherein a first magnetic concentrator is provided at the front side, and a second magnetic concentrator is provided at the back side, both arranged for guiding magnetic flux lines through the same magnetic sensor element.

It is an object of embodiments of the present invention to provide a method of producing a semiconductor wafer comprising a plurality of integrated Magnetic Flux Concentrators (IMC), wherein the method is fully compatible or highly compatible with the CMOS process.

It is an object of embodiments of the present invention to provide a method of producing a semiconductor wafer comprising a plurality of integrated Magnetic Flux Concentrators (IMC) and (a) CMOS circuit(s).

It is an object of embodiments of the present invention to provide a method of producing semiconductor dies comprising at least one solid state magnetic sensor element and optionally further processing circuitry (e.g. a biasing and readout circuit, and/or an amplifier, and/or an ADC, and/or a digital processing circuit, and preferably all of these) wherein the at least one magnetic sensor element is arranged between two IMC, one at the front side of the semiconductor die, and one at the back side of the semiconductor die, and wherein the semiconductor die can be or is wire bonded, and wherein the semiconductor die can be or is encapsulated in a plastic or ceramic package.

It is an object of embodiments of the present invention to provide a reliable method for producing devices for automotive, industrial or robotic applications.

These and other objectives are accomplished by embodiments of the present invention.

According to a first aspect, the present invention provides a method of producing a semiconductor substrate (e.g. a semiconductor wafer or a semiconductor die), comprising the following steps: a) providing a semiconductor wafer comprising: a front side or a device layer and a back side (e.g. a bulk layer), and an interconnection stack situated on top of the device layer, wherein the device layer comprises at least one embedded magnetic sensor element, and wherein the interconnection stack comprises a plurality of contact areas; m) mounting a carrier wafer to the front side of the semiconductor wafer; b) thinning the back side of the semiconductor wafer; c) providing at least one magnetic concentrator on or to the front side of the semiconductor wafer, e.g. in the vicinity of the at least one magnetic sensor element; d) providing at least one magnetic concentrator on or to the back side of the semiconductor wafer, e.g. in the vicinity of the at least one magnetic sensor element; wherein step m) is performed before step b) to provide mechanical support such that the wafer can be further processed without being damaged.

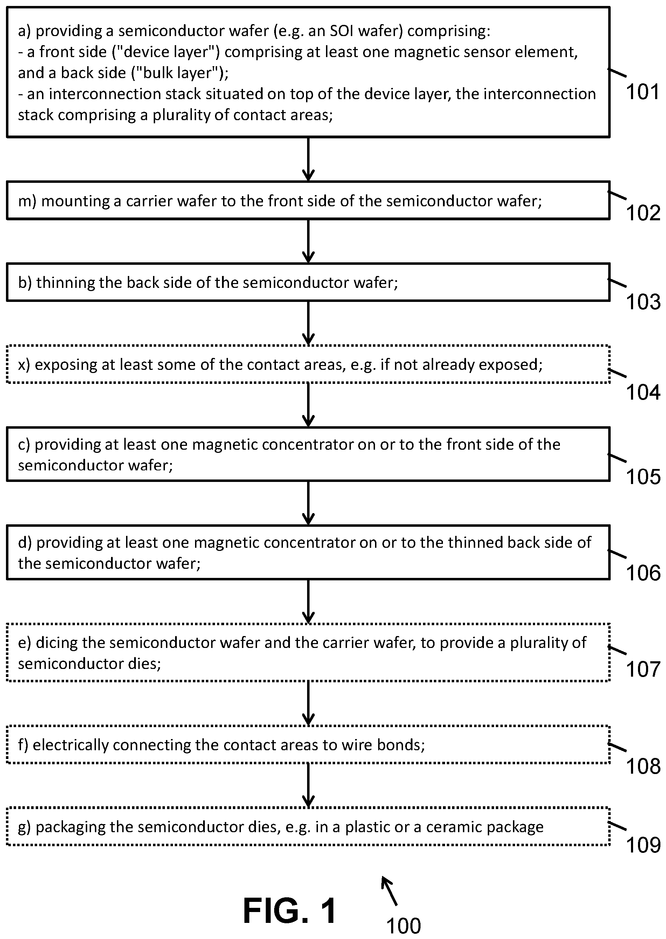

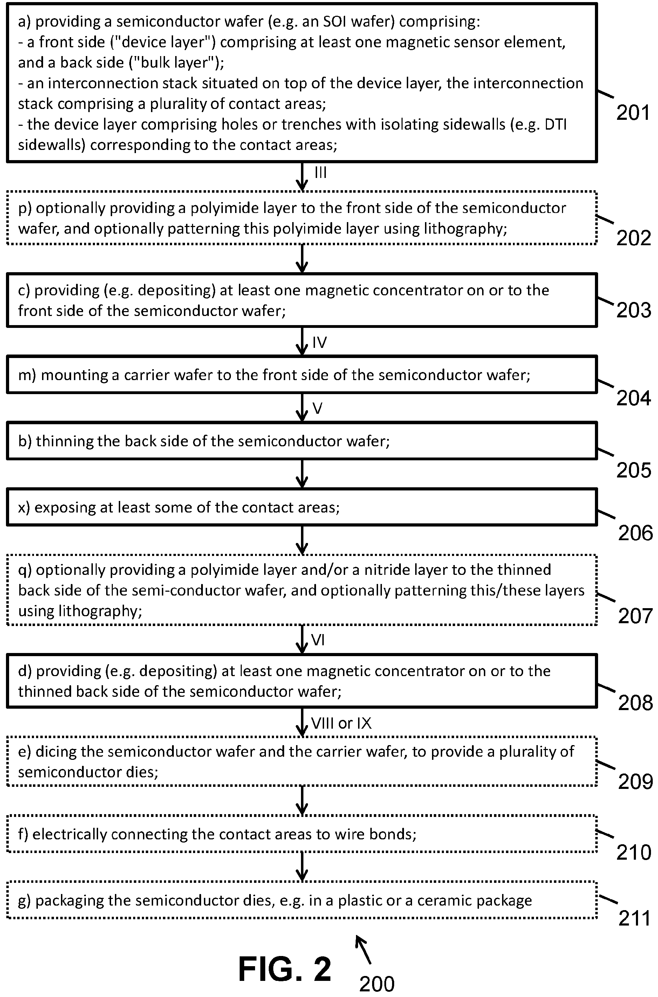

A flow-chart of this method is illustrated in FIG. 1. The steps of this method may be performed in a different order, and additional steps may be added. Three specific examples of this method are illustrated in FIG. 2, FIG. 11 and FIG. 17.

It is an advantage of providing an IMC in the vicinity of the magnetic sensor element, because IMC concentrates and bends magnetic field lines so that they can be measured by the magnetic sensor element, and because the IMC provides a passive gain, thus effectively increasing the sensitivity, and as a consequence also improving signal-to-noise ratio (SNR), and/or decreasing measurement error, resulting for example in more accurate linear or angular position, a more accurate current, etc.

It is an advantage of providing an IMC both at the front side of the wafer, and at the back side of the wafer, because it increases the effect (e.g. almost doubles the effect).

It is an advantage of thinning the backside of the semiconductor wafer, because by doing so, the distance between the front IMC and the back IMC can be further reduced, and thus the effect of concentrating magnetic field lines can be further increased.

It is a further advantage of using a silicon wafer, or a silicon-on-insulator wafer, because it allows to embed the at least one magnetic sensor element, but it also allows to implement other electrical components and/or circuitry (such as e.g. biasing and readout circuit, an amplifier, an ADC, a digital processor, a temperature sensor, a non-volatile memory, etc.), thereby providing a largely integrated solution.

The semiconductor wafer preferably comprises a plurality of die areas (e.g. at least 50 die areas) that will be separated from each other in a later step, known as "dicing". The carrier wafer that is mounted to the semiconductor wafer in step m) is a single piece that has substantially the same size as the semiconductor wafer (e.g. within a tolerance margin of ±10%), and that will also be separated in multiple pieces during the step of "dicing" (illustrated as step e) in FIG. 1, FIG. 2, FIG. 11 and FIG. 17). In other words, the connection between the semiconductor wafer and the carrier wafer is a wafer-to-wafer connection, and is not a mounting of a plurality of individual dies on the semiconductor wafer.

Preferably the front IMC and the back IMC have a thickness in the range from 1.0 to 40 µm, and/or preferably have a lateral dimension (e.g. a diameter, a length, a width) in the range from 1.0 to 500 µm.

In a preferred embodiment, step b) comprises "reducing the thickness of the semiconductor wafer uniformly", e.g. by grinding, by etching, by CMP (chemical and mechanical polishing), or in any other suitable way. By thinning the semiconductor wafer uniformly, the risk of mechanical stress concentration and/or the risk of cracks is drastically reduced.

It is an advantage of the combination of step m) ("mounting a carrier wafer") followed by step b) ("thinning the semiconductor wafer"), that the carrier wafer can provide additional mechanical support, allowing not only a safe use of more aggressive subtractive manufacturing techniques for thinning the wafer, but also resulting in a larger and/or broader surface area for providing one or more magnetic concentrators without damaging the wafer. Thanks to the carrier wafer the thickness of the semiconductor wafer can be dramatically reduced. The "uniformly thinned" surface can advantageously be used for providing magnetic concentrators having various shapes and sizes, e.g. larger or broader than certain prior art concentrators which are formed in a cavity. The magnetic concentrator(s) located on the top side, and the magnetic concentrator(s) located on the bottom side may be spaced apart by only a very small distance, and in some embodiments, they may be disposed on the same substrate (wafer).

Step b) may comprise: reducing the thickness of the semiconductor wafer (excluding any cavity wafer) to a value in the range from 1.0 to 20.0 µm, e.g. equal to about 4.0 µm. If the semiconductor wafer is an SOI-wafer, then step b) may comprise: removing the "bulk layer" 02 completely.

In an embodiment, the semiconductor substrate is a silicon substrate, or comprises mainly silicon.

In an embodiment, the semiconductor substrate is a silicon substrate, or comprises mainly silicon, and the device layer further comprises at least one electronic component or circuit implemented using CMOS technology.

In an embodiment, the semiconductor material is selected from the III-V-group, for example Ga-As or In-As.

Preferably the at least one IMC located at the front side (also referred to as "front IMC") and the at least one IMC located at the back side (also referred to as "back IMC") are planar, meaning that they have a constant thickness measured in the Z-direction (perpendicular to the semiconductor wafer).

According to some embodiments of the present invention, the semiconductor wafer comprises an electronic circuit having a feature size less than or equal to 200 nm, or less than or equal to 180 nm, or less than or equal to 110 nm. The present invention is particularly useful for small technology nodes, for which typically a relatively thick substrate is present (e.g. having a thickness of at least 500 µm, e.g. equal to about 525 µm, or equal to about 750 µm).

In an embodiment, at least some of the contact areas (12) of the semiconductor substrate provided in step a) are exposed.

In an embodiment, the method further comprises one or more of the following steps: x) exposing at least some of the contact areas; e) dicing the semiconductor wafer and the carrier wafer, to provide a plurality of semiconductor dies; f) electrically connecting the contact areas to wire bonds; g) packaging the semiconductor dies, e.g. in a plastic or a ceramic package.

In an embodiment, step a) comprises: providing a silicon-on-insulator (SOI) wafer comprising a device layer comprising silicon, and a bulk layer comprising silicon, and further comprising a buried-oxide located between the device layer and the bulk layer; and wherein step b) comprises: reducing a thickness of the bulk layer by removing at least 40%, or at least 50% or at least 60% or at least 70% or at least 80% or at least 90% of the silicon layer on the back-side of the SOI-wafer, e.g. by etching or by grinding, or completely removing the bulk layer by etching the silicon at the back side using the buried oxide layer as an etch stop.

While using an SOI wafer is very useful, it is pointed out that the present invention is not limited thereto, and other semiconductor substrates can also be used.

In an embodiment, step b) comprises: completely removing the silicon at the back side of the semiconductor substrate.

In an embodiment, step b) comprises: removing at most 90% of the silicon layer on the back side of the SOI wafer, or at most 80%, or at most 70%, or at most 60%, or at most 50%.

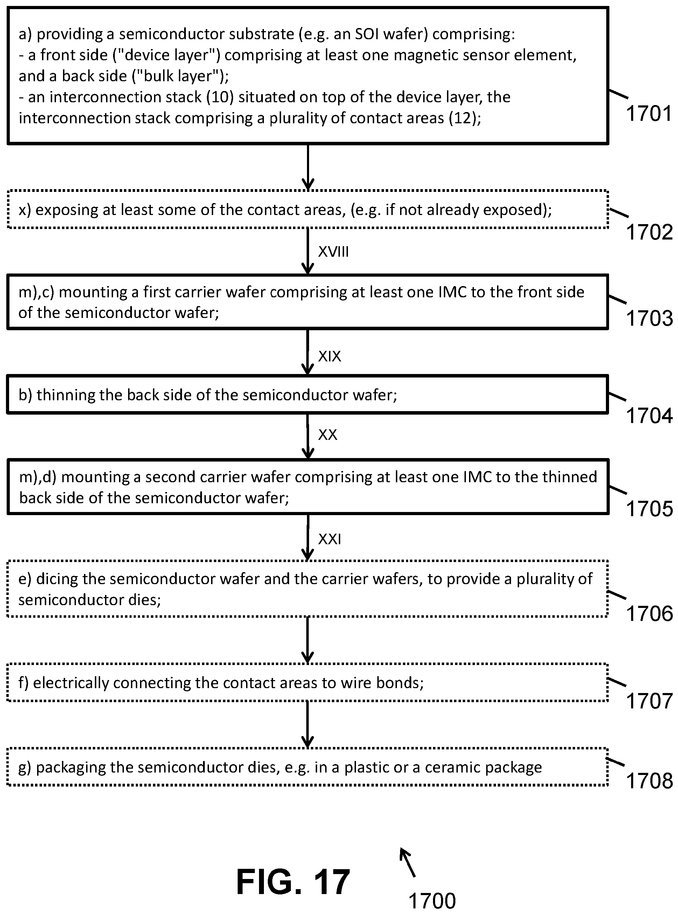

In an embodiment, step m) comprises: mounting said carrier wafer permanently to the semiconductor wafer, e.g. as in step 204 of FIG. 2, or as in step 1703 of FIG. 17.

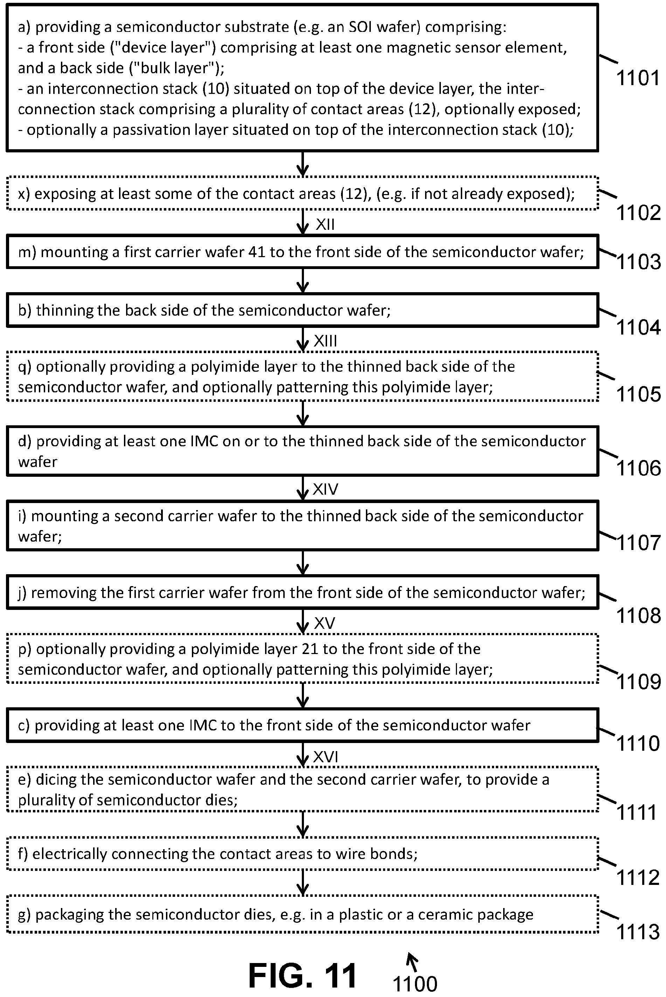

In an embodiment, step m) comprises: mounting said carrier wafer temporarily to the semiconductor wafer, e.g. as in step 1103 of FIG. 11.

In an embodiment, the method further comprises at least one of the following steps: p) providing a stress-reduction layer on or to the front side of the semiconductor wafer before performing step c); q) providing a stress-reduction layer to the thinned back side of the semiconductor wafer before performing step d).

By doing so, mechanical stress between the IMC and the material of the semiconductor wafer may be reduced.

The stress-reduction layer(s) may be or may comprise (a) polyimide layer(s).

In an embodiment, step c) is performed before step b); and step c) comprises: depositing at least one layer of ferromagnetic material on or to the front side of the semiconductor wafer, e.g. by electroplating, sputtering , or combinations thereof, and by optionally patterning this at least one IMC layer; and step d) comprises: depositing at least one layer of ferromagnetic material to the thinned back side of the semiconductor wafer, e.g. by electroplating, sputtering, or combinations thereof, and by optionally patterning this at least one IMC layer.

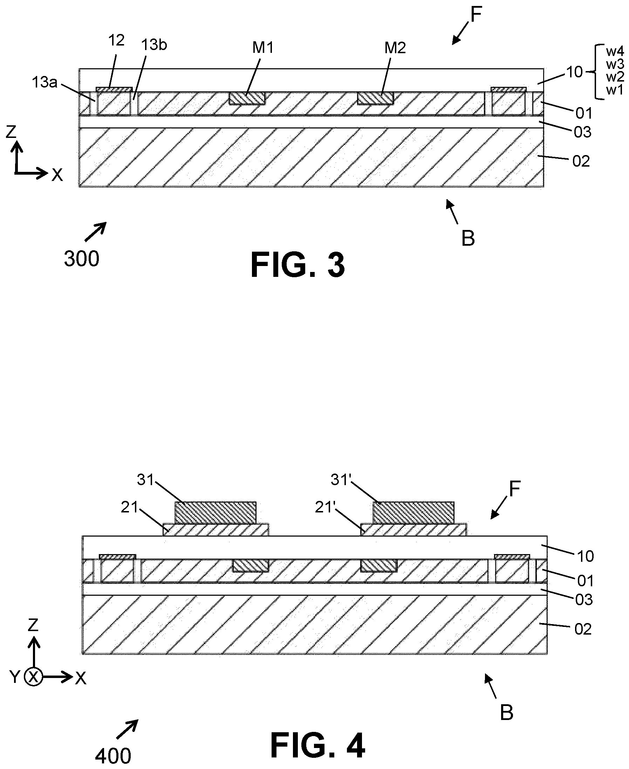

A flow-chart of this method is illustrated in FIG. 2, and illustrative examples of semiconductor substrates (e.g. semiconductor wafers or semiconductor dies) that can be obtained by performing some or all these steps, are shown in FIG. 3 to FIG. 9.

In an embodiment, step d) is performed before step c); and step m) is performed before step b), and comprises: mounting a first carrier wafer to the front side of the semiconductor wafer; and the method further comprises step i), after step d), of mounting a second carrier wafer to the thinned back side of the semiconductor wafer; and the method further comprises step j), before step c), of removing the first carrier wafer mounted to the front side of the semiconductor wafer.

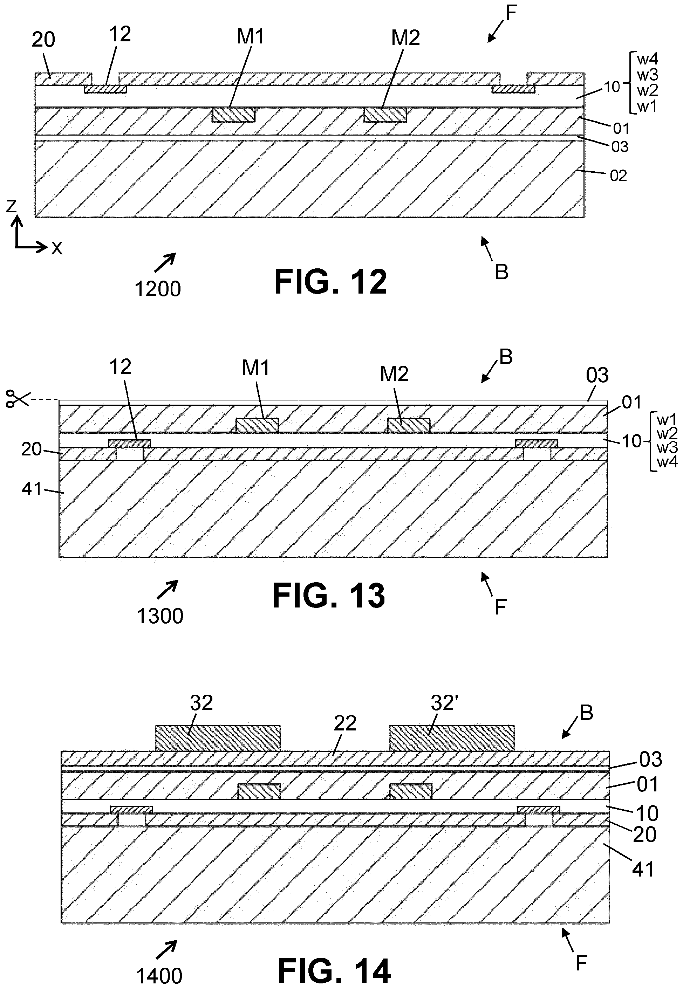

A flow-chart of this method is illustrated in FIG. 11, and illustrative examples of semiconductor substrates (e.g. semiconductor wafers or semiconductor dies) as can be obtained by performing some or all of these steps are shown in FIG. 12 to FIG. 16.

In an embodiment, step c) is performed before step b); and step c) comprises: mounting a first cavity wafer comprising at least one magnetic concentrator to the front side of the semiconductor wafer; and step d) comprises: mounting a second cavity wafer comprising at least one magnetic concentrator to the thinned back side of the semiconductor wafer.

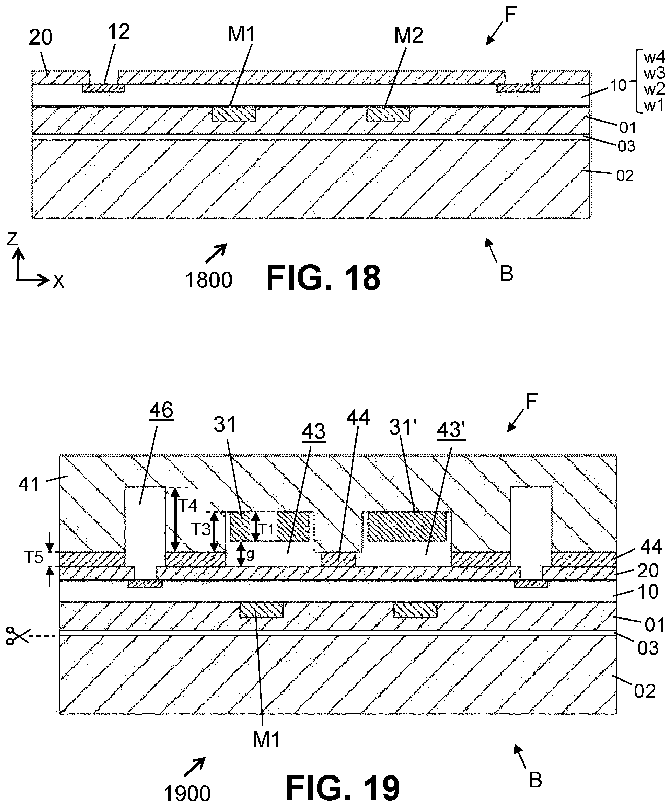

A flow-chart of this method is illustrated in FIG. 17, and illustrative examples of semiconductor wafers as can be obtained by performing some or all of these steps, are shown in FIG. 18 to FIG. 22.

In an embodiment, step c) comprises: providing the first carrier wafer having a first plurality of recesses or cavities having a first depth for accommodating said at least one IMC, and having a second plurality of recesses or cavities or grooves having a second depth larger than the first depth; and the method further comprises a step of reducing a thickness of the first carrier wafer for opening the second plurality of recesses or cavities or grooves thereby exposing the at least one contact area.

In an embodiment, the at least one magnetic concentrator provided in step c) has a circular disk shape, and the at least one magnetic concentrator provided in step d) has an elongated shape (e.g. an overall trapezoidal shape or an elliptical shape), or vice versa.

In an embodiment, the at least one magnetic concentrator provided in step c) has a circular disk shape, and the at least one magnetic concentrator provided in step d) also has a circular disk shape.

In an embodiment, the at least one magnetic sensor element is a horizontal Hall element, and an orthogonal projection of the magnetic sensor element and an orthogonal projection of the at least one magnetic concentrator provided at the front side, and an orthogonal projection of the at least one magnetic concentrator provided at the back side, overlap at least partially.

Preferably an orthogonal projection of each of the front IMC and the back IMC overlaps an orthogonal projection of the at least one horizontal Hall element by at least 50% of the area of the horizontal Hall plate, or at least 60%, or at least 70%, or at least 80%, or at least 90%, or at least 95%.

The area of the at least one horizontal Hall element may be substantially square.

The size (e.g. length and width) of the at least one horizontal Hall element may be a value in the range from 15 µm to 29 µm.

In an embodiment, the at least one magnetic sensor element is a vertical Hall element or a magneto-resistive element (e.g. a GMR element, an AMR element, an XMR element, a TMR element), and wherein an orthogonal projection of the magnetic sensor element is located between an orthogonal projection of the at least one magnetic concentrator provided at the front side, and an orthogonal projection of the at least one magnetic concentrator provided at the back side.

In an embodiment, a distance between the front IMC and the back IMC measured in a direction perpendicular to the semiconductor substrate is smaller than 200 µm, or smaller than 100 µm, or smaller than 50 µm, for example a value in the range from 10 to 40 µm, or in the range from 10 to 30 µm, e.g. equal to about 15 µm, or equal to about 18 µm, or equal to about 21 µm, or equal to about 24 µm, or equal to about 27 µm.

In an embodiment, the device layer has a thickness from 3.0 to 5.0 µm (e.g. equal to about 4 µm), and the interconnection stack has a thickness from 3.0 to 5.0 µm (e.g. equal to about 4 µm), and each of the front IMC and the back IMC is located on a polyimide layer having a thickness from 3.0 to 7.0 µm (e.g. equal to about 5 µm), hence a distance between the front IMC and the back IMC (measured in a direction perpendicular to the semiconductor substrate) is a value in the range from 12.0 to 24.0 µm (e.g. equal to about 18 µm).

In an embodiment, step m) comprises: mounting a carrier wafer comprising a plurality of cavities.

In an embodiment, step m) comprises: mounting a carrier wafer that is planar without any cavities.

In an embodiment, the present invention also provides a method according to the first aspect, similar to that of FIG. 2 to FIG. 9 of the present application, but wherein the IMC is not deposited on top of the interconnection stack, but is situated at least partially within the interconnection stack, e.g. using a method as described in EP3742182(A1) or using a method as described in co-pending patent application EP24174812.8 filed on 08 May 2024, both of these documents being incorporated herein by reference in their entirety.

According to a second aspect, the present invention also provides a magnetic sensor device comprising: a semiconductor substrate comprising: a front side or a device layer and a back side, and an interconnection stack (situated on top of the device layer, wherein the device layer comprises at least one embedded magnetic sensor element, and wherein the interconnection stack comprises a plurality of contact areas; at least one magnetic concentrator on or to the front side of the semiconductor substrate; at least one magnetic concentrator on or to the back side of the semiconductor substrate.

According to a third aspect, the present invention also provides a magnetic sensor device comprising: a semiconductor substrate comprising: a front side or a device layer and a back side, wherein the device layer comprises at least one embedded magnetic sensor element, at least one magnetic concentrator on or to the front side of the semiconductor substrate; at least one magnetic concentrator on or to the back side of the semiconductor substrate; wherein a distance (Δz) between the at least one magnetic concentrator at the front side and the at least one magnetic concentrator at the back side, measured in a direction (Z) perpendicular to the semiconductor substrate, is smaller than 200 µm.

According to a fourth aspect, the present invention also provides a semiconductor wafer, produced by a method according to the first aspect.

According to a fifth aspect, the present invention also provides an integrated semiconductor device, obtained or obtainable from a semiconductor wafer according to the fourth aspect, after dicing and wire bonding and packaging.

In an embodiment, the device according to the second or third or fifth aspect comprises one or more of the following features:
wherein a distance (Δz) between the at least one magnetic concentrator at the front side and the at least one magnetic concentrator at the back side, measured in a direction (Z) perpendicular to the semiconductor substrate, is smaller than 200 µm;
- wherein the at least one magnetic concentrator at the front side and the at least one magnetic concentrator at the back side have a planar shape;
- wherein orthogonal projections of the at least one magnetic concentrator at the front side, and the at least one magnetic concentrator at the back side, and the at least one magnetic sensor element (M1) onto the semiconductor substrate at least partially overlap;
- wherein the semiconductor substrate further comprises a passivation layer;
- wherein the semiconductor substrate further comprises a dielectric layer at the back side, e.g. an oxide layer;
- wherein the semiconductor substrate further comprises a polyimide layer situated between the semiconductor substrate and the at least one magnetic concentrator at the front side;
- wherein the semiconductor substrate further comprises a polyimide layer situated between the semiconductor substrate and the at least one magnetic concentrator at the back side;
- wherein the sensor device further comprises a carrier substrate mounted to the semiconductor substrate such that the at least one magnetic concentrator at the front side is located between the semiconductor substrate and the carrier substrate, the carrier substrate optionally having at least one cavity or optionally being planar without any cavity;
- wherein the sensor device further comprises a carrier substrate mounted to the semiconductor substrate such that the at least one magnetic concentrator at the back side is located between the semiconductor substrate and the carrier substrate, the carrier substrate optionally having at least one cavity or optionally being planar without any cavity;
- wherein the at least one magnetic sensor element is at least one horizontal Hall element or at least one vertical Hall element;
- wherein the magnetic sensor device is a current sensor device;
- wherein the magnetic sensor device is a linear position sensor device;
- wherein the magnetic sensor device is an angular position sensor device;
- wherein the magnetic sensor device is a proximity sensor device;
- wherein the magnetic sensor device is a pressure sensor device;
- wherein the magnetic sensor device is a force sensor device;
- wherein the magnetic sensor device is a torque sensor device;
- wherein the magnetic sensor device is a force sensor device;
- wherein the magnetic sensor device is a speed sensor device;
- wherein the magnetic sensor device is an electronic compass.

In an embodiment, the device according to the second or third or fifth aspect further comprises a processing circuit connected to said at least one magnetic sensor element, configured for determining one or more of the following: a current value, one or more angular position values, one or more linear position values, a proximity value, one or more pressure values, one or more force values, a torque value, a speed value, an acceleration value.

In an embodiment, the device according to the second or third or fifth aspect may further comprise one or more of the following: a biasing and readout circuit, an amplifier, an analog-to-digital convertor, a digital processor, a temperature sensor, a non-volatile memory.

Particular and preferred aspects of the present invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1** shows a flow-chart of a method of producing a semiconductor substrate (e.g. a semiconductor wafer or a semiconductor die), according to an embodiment of the present invention.
**FIG. 2** shows a flow-chart of a first specific example of a method of producing a semiconductor substrate (e.g. a semiconductor wafer or a semiconductor die), as an embodiment of the present invention. The method of FIG. 2 is a special case of the method of FIG. 1.
**FIG. 3 to FIG. 9** show cross-sections of intermediate semiconductor substrates (e.g. wafers or dies), as can be obtained by performing some or all of the steps of the method of FIG. 2.
**FIG. 10** shows an illustrative example of a possible shape for at least one first IMC located above the at least one magnetic sensor element, and for the at least one second IMC located below the same at least one magnetic sensor element, but of course, the present invention is not limited hereto.
**FIG. 11** shows a flow-chart of a second specific example of a method of producing a semiconductor substrate (e.g. a semiconductor wafer or a semiconductor die), as an embodiment of the present invention. The method of FIG. 11 is a special case of the method of FIG. 1.
**FIG. 12 to FIG. 16** show cross-sections of intermediate semiconductor substrates (e.g. wafers or dies), as can be obtained by performing some or all of the steps of the method of FIG. 11.
**FIG. 17** shows a flow-chart of a third specific example of a method of producing a semiconductor substrate (e.g. a semiconductor wafer or a semiconductor die), as an embodiment of the present invention. The method of FIG. 17 is a special case of the method of FIG. 1.
**FIG. 18 to FIG. 22** show cross-sections of intermediate semiconductor substrates (e.g. wafers or dies), as can be obtained by performing some or all of the steps of the method of FIG. 17.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The same or similar reference numerals (modulo 100) may be used to indicate same or similar structural features in different embodiments.

In this document, the expression "interconnection stack" or "metal stack" refer to a stack of layers comprising at least two (e.g. four) "wire layers" of conductive material (e.g. Al or Cu) separated by layers comprising dielectric material. The "wire layers" are typically patterned and typically comprise a plurality of tracks and/or regions for conducting electrical signals or forming contact areas (e.g. bond pads). Wires of different wire layers may be interconnected using "vias".

In this document, the expression "the IMC at the front side" actually means "the at least one IMC at the front side", and the expression "the IMC at the back side" actually means "the at least one IMC at the back side", and the expression "the magnetic sensor element" or "the magnetic sensor" actually means "the at least one magnetic sensor element".

In this document, the expression "the front side of the semiconductor wafer" means "the side of the wafer proximal to the device layer, and "the back of the semiconductor wafer" means the side of the wafer distal from the device layer.

The present invention relates to the field of semiconductor substrates (e.g. semiconductor wafers or semiconductor dies) comprising at least one magnetic sensor element (e.g. selected from the group consisting of: a horizontal Hall element, a vertical Hall element, a magneto-resistive (MR) element, an AMR element, a GMR element, a TMR element, an XMR element), and at least two Magnetic Flux Concentrators (IMC), and optionally further comprising one or more of the following: a biasing and readout circuit, an amplifier, an analog-to-digital convertor (ADC), an electrical processing circuit, e.g. a digital processing circuit, a non-volatile memory, etc.

The present invention also relates to methods of producing such semiconductor substrates (e.g. semiconductor wafers or semiconductor dies), and to semiconductor devices comprising such semiconductor substrates, e.g. integrated semiconductor devices packaged in a plastic or ceramic moulding compound, typically referred to as "ICs" or "chips".

The present invention will be mainly explained and illustrated assuming that the semiconductor substrate is a Silicon-On-Insulator (SOI) wafer with two horizontal Hall elements, for ease of the description, but the present invention is not limited hereto, and the methods described herein can also be used with other semiconductor wafers, e.g. silicon wafers, or wafers comprising a compound semiconductor material selected from the III-V-group, for example Ga-As or In-As, comprising one or more solid state magnetic sensor elements (e.g. horizontal Hall elements, vertical Hall elements, MR elements).

### Referring to the Figures.

**FIG. 1** shows a flow-chart of a method 100 for producing a semiconductor substrate (e.g. a semiconductor wafer or a semiconductor die). The method 100 comprises the following steps:
a) providing 101 a semiconductor wafer (e.g. an SOI wafer) comprising: a front side (also know as "device layer") comprising at least one magnetic sensor element, and a back side. The semiconductor substrate further comprises an interconnection stack 10 situated on top of the device layer. The interconnection stack 10 comprises a plurality of contact areas 12.
   The magnetic sensor element is preferably embedded in the device layer. The contact areas 12 may be exposed. There may also be a passivation layer 20 on top of the interconnection stack 10.
      m) mounting (e.g. bonding) 102 a carrier wafer to the front side of the semiconductor wafer.
   The carrier wafer offers mechanical support to the semiconductor wafer, especially after it is thinned in the next step. This carrier wafer may be temporarily bonded to the semiconductor wafer, or permanently.
b) thinning 103 the back side of the semiconductor wafer;
   For example by grinding, back-grinding and/or etching. A combination of grinding and etching can also be used, because grinding is fast, but etching provides a more precise finishing.
c) providing 105 at least one magnetic concentrator 31 on or to the front side of the semiconductor wafer;
d) providing 106 at least one magnetic concentrator 32 on or to the thinned back side of the semiconductor wafer.

The method 100 may further comprise one or more of the following optional steps:
x) exposing 104 at least some of the contact areas 12, e.g. if not already exposed;
e) dicing 107 the semiconductor wafer and the carrier wafer, to provide a plurality of semiconductor dies;
f) electrically connecting 108 (some or all) the contact areas 12 to wire bonds, e.g. for electrically connecting the contacting areas 12 to elongated leads of a lead-frame.
g) packaging the semiconductor dies, e.g. in a plastic or a ceramic package, e.g. by applying a molding compound.

The steps of this method may be performed in a different order than shown in FIG. 1, and additional steps may be added. Three illustrative examples of this method will be shown in FIG. 2, FIG. 11 and FIG. 17, but the present invention is not limited to these examples.

It is an advantage of providing a magnetic concentrator (IMC) in the vicinity of the at least one magnetic sensor element, because the IMC bends magnetic field lines, such that they can be measured by the at least one magnetic sensor element, and because the IMC provides a magnetic gain, thus effectively increasing the sensitivity, and as a consequence also improving signal-to-noise ratio (SNR), and decreasing measurement error (e.g. more accurate position, more accurate current, etc.)

It is an advantage of providing an IMC both at the front side of the wafer, and at the back side of the wafer, because it further increases the magnetic gain.

It is a further advantage of decreasing the distance between the IMC at the front side, and the IMC at the back side, by thinning the semiconductor wafer, thereby further increasing the effect.

It is a further advantage of using a silicon wafer, or a silicon-on-insulator (SOI) wafer, because it allows to embed the magnetic sensor element, and optionally also other electronic circuits, such as e.g. one or more of: a biasing and readout circuit, an amplifier, an analog-to-digital convertor (ADC), a digital signal processor, a non-volatile memory, etc.), thereby providing a largely integrated solution.

While the "mere idea" of making "a semiconductor circuit comprising a magnetic sensor element, e.g. a solid-state magnetic sensor element, arranged between two magnetic flux concentrators", arranged closely together at different height positions (in the Z-direction) may seem conceptually simple at first, providing a reliable process for making such integrated circuits at an industrial scale, especially for automotive, industrial or robotic applications, is a completely different story.

In order to find a workable and commercially viable solution, the inventors were faced inter alia with the following conflicting requirements: (1) to find a way to decrease the distance between the first IMC and the second IMC, (2) to make sure that the semiconductor wafer is sufficiently strong to be processed without being damaged, (3) to be able to connect the resulting semiconductor dies by means of wire bonding. For a while, the inventors were pondering the following combined problem: "thinning the substrate" can bring the IMCs closer together but weakens the substrate; adding a carrier wafer at the top or bottom side can offer mechanical enforcement but makes the bond pads inaccessible. The present invention provides a solution to this combined problem, and thus is an enabler for making such products.

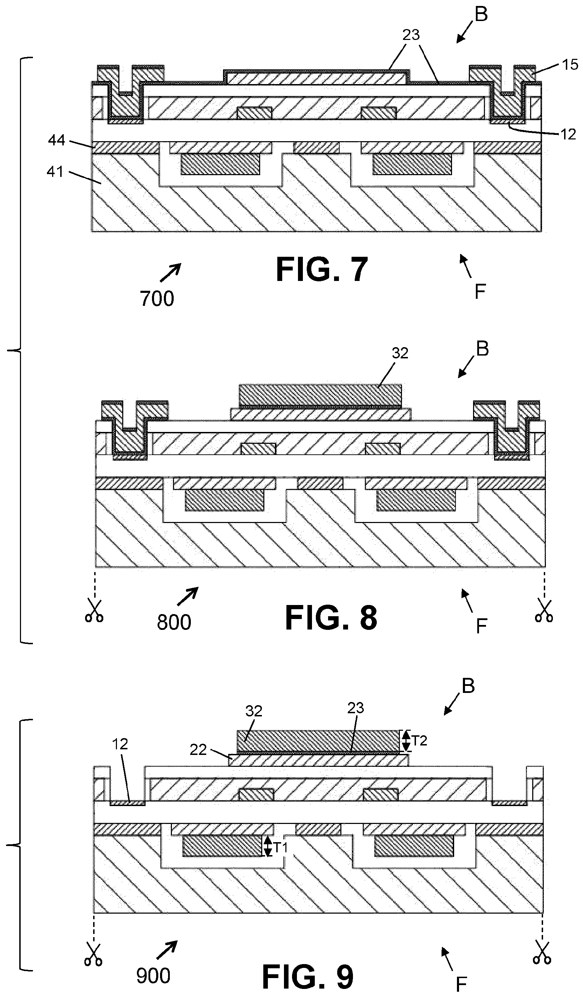

**FIG. 2** shows a flow-chart of a method 200 for producing a semiconductor substrate, e.g. the semiconductor wafer/die 800 or 900 shown in FIG. 8 or FIG. 9 before/after dicing the semiconductor wafer and the carrier wafer.

The resulting semiconductor wafer/die may comprise a relatively thin semiconductor substrate (e.g. a CMOS substrate) comprising at least one magnetic sensor element, and having at least one IMC at its front side (also referred to as "front IMC"), and at least one IMC at its back side (also referred to as "back IMC"), wherein a distance Δz between the IMC's measured in a direction Z perpendicular to the semiconductor substrate is smaller than 200 µm, or smaller than 150 µm, or smaller than 125 µm, or smaller than 100 µm, or smaller than 75 µm, or smaller than 50 µm, or smaller than 40 µm, or smaller than 30 µm, or smaller than 20 µm.

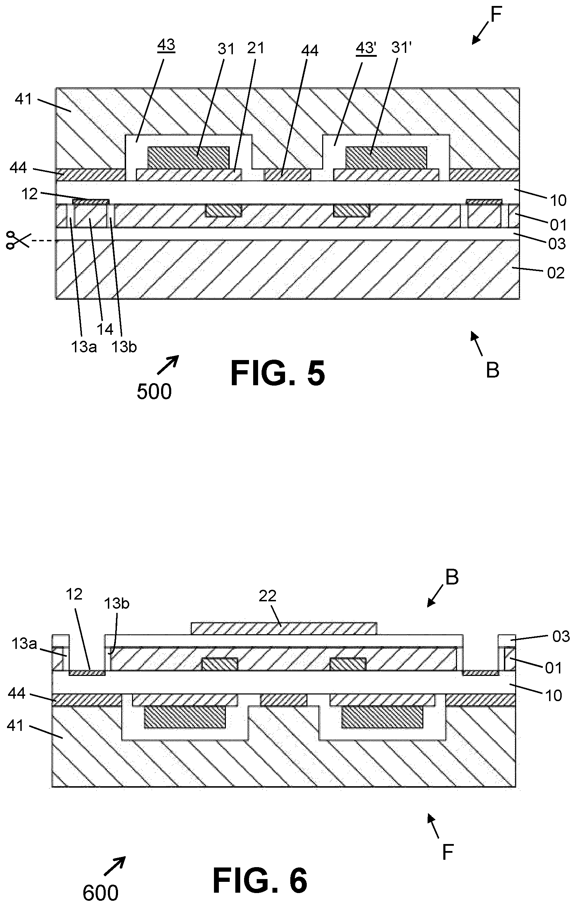

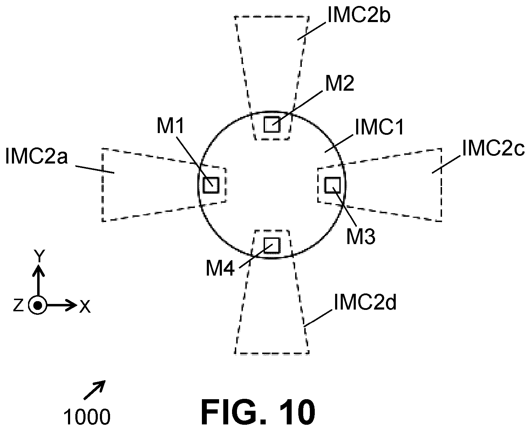

The method 200 of FIG. 2 can be seen as a special case of the method 100 of FIG. 1, and has the following steps:
a) providing 201 a semiconductor wafer (e.g. an SOI wafer) comprising: a front side (e.g. device layer 01) comprising at least one magnetic sensor element (e.g. M1, M2) and a back side (e.g. bulk layer 02); an interconnection stack 10 situated on top of the device layer, the interconnection stack comprising a plurality of contact areas 12; the device layer 01 furthermore comprising holes or trenches with an isolating material (e.g. polyimide) at is sidewalls, e.g. DTI (Deep Trench Isolation) sidewalls, corresponding to (e.g. aligned in the Z-direction) to the contact area 12 (e.g. with a predefined overlap); An example of such a semiconductor wafer 300 is illustrated in FIG. 3. The device layer 01 may contain one or more embedded components or circuits, e.g. implemented using a CMOS process. The front side is pointed to by arrow "F". The back side of the semiconductor wafer is pointed to by arrow "B".
p) optionally providing (e.g. depositing, e.g. by spin-coating) 202 a polyimide layer 21 to the front side of the semiconductor wafer, and optionally patterning this polyimide layer using lithographical techniques.
c) providing (e.g. depositing) 203 at least one magnetic concentrator 31 on or to the front side of the semiconductor wafer;
   An example of a semiconductor wafer 400 derived from the semiconductor wafer 300 of FIG. 3 after performing step p) and step c) is illustrated in FIG. 4. The at least one magnetic concentrator 31, 31' may for example be deposited by electroplating, sputtering, or combinations hereof. The lateral position of the at least one IMC 31, 31' may be chosen to correspond with the position(s) of the at least one magnetic sensor M1, M2, e.g. such that an orthogonal projection of the magnetic sensor is situated near a center, or near a periphery of the IMC, or is situated at a predefined distance from the periphery in a nonoverlapping position (e.g. as illustrated in FIG. 10), or is situated at a predefined distance from the periphery in an overlapping position.
m) mounting 204 a carrier wafer 41 to the front side of the semiconductor wafer;
   An example of a semiconductor wafer 500 derived from the semiconductor wafer 400 of FIG. 4 after performing step m) is illustrated in FIG. 5. In the example shown in FIG. 5, the carrier wafer is a cavity wafer which is bonded to the semiconductor wafer, e.g. using glass frit bonding, but the present invention is not limited hereto, and other bonding techniques such as e.g. eutectic bonding, direct metal diffusion bonding, anodic bonding, or bonding with an adhesive layer may also be used.
b) thinning 205 the back side of the semiconductor wafer;
   For example by grinding, back-grinding and/or etching, as schematically indicated by the scissors symbol in FIG. 5. In this example, the bulk layer 02 is completely removed, e.g. by etching the backside of the SOI wafer to the buried oxide layer 03.
x) exposing 206 at least some of the contact areas 12;
   For example by making an opening in the buried oxide layer 03 in the vicinity of the holes or trenches with isolating sidewalls (e.g. DTI sidewalls), and by removing (e.g. etching) a portion 14 of the material (e.g. silicon) between the isolating sidewalls 13a, 13b, downto the contact area 12, if needed.
q) optionally providing 207 a polyimide layer and/or a nitride layer 22 to the thinned back side of the semiconductor wafer, and optionally patterning this or these layers 22 using lithography;
   An example of a semiconductor wafer derived from the semiconductor wafer of FIG. 5 after performing steps b) and x) and q) is illustrated in FIG. 6.
d) providing (e.g. depositing) 208 at least one magnetic concentrator 32 on or to the thinned back side of the semiconductor wafer;
   For example by electroplating, sputtering, or combinations hereof.
   Examples of semiconductor wafers derived from the semiconductor wafer of FIG. 6 after performing step d) are illustrated in FIG. 8 and in FIG. 9, showing two alternatives, as will be explained further (in FIG. 7 to FIG. 9).

The method 200 may optionally further comprise one or more of the following steps:
e) dicing 209 the semiconductor wafer and the carrier wafer, to provide a plurality of semiconductor dies;
f) electrically connecting 210 the contact areas 12 to bond wires (not explicitly shown), e.g. for electrically connecting the contacting areas to elongated leads of a lead-frame;
g) packaging 211 the semiconductor dies, e.g. in a plastic or a ceramic package, e.g. by applying a molding compound.

**FIG. 3 to FIG. 9** show cross-sections of intermediate semiconductor wafers, as can be obtained by performing some or all of the steps of the method 200 of FIG. 2.

**FIG. 3** shows a cross-section of an SOI wafer 300, comprising a device layer 01, a buried oxide layer 03, and a bulk silicon layer 02. Only a single die area of the wafer is shown in FIG. 3. In practice a wafer may typically comprises more than 50, or more than 100, or even more than 1000 identical semiconductor dies.

The device layer 01 comprises at least one magnetic sensor element M1, M2, and comprises holes or trenches with isolating sidewalls, e.g. DTI (deep trench isolation) walls 13a, 13b. The semiconductor substrate also comprises an interconnection stack 10 located above the device layer 01. While not explicitly shown, there may be a passivation layer located above the interconnection stack 10.

When referring to "the front side" of the semiconductor wafer, reference is made to the side of the semiconductor wafer proximal to the interconnection stack 10, pointed to by arrow "F" in FIG. 3. When referring to the "back side" of the semiconductor wafer, reference is made to the side of the semiconductor wafer, distal from the interconnection stack 10, pointed to by arrow "B" in FIG. 3. In case the semiconductor wafer is an SOI-wafer, the back side of the semiconductor wafer refers to the side that (originally) contains the bulk silicon layer 02. As will be described further, the bulk silicon layer 02 will be thinned (e.g. its thickness will be reduced by at least 50%, or at least 60%, or at least 70%, or at least 80%, or at least 90%) or even completely removed.

The device layer 01 of the semiconductor wafer 300 comprises at least one magnetic sensor element M1, M2 (e.g. two horizontal Hall elements). The interconnection layer 10 (also referred to as "interconnection stack" or "metal stack") comprises a plurality of "wire layers", e.g. four wire layers w1, w2, w3, w4, separated from each other by dielectric layers. As is known in the art, excitation signals are applied to the magnetic sensor(s) via the interconnection stack, and output signals are obtained from the magnetic sensor(s) via the interconnection stack.

The interconnection stack 10 also comprises a plurality of contact zones 12 (also referred to as "contact areas", or "bond pads" when exposed). Although not absolutely required, the contact zones 12 are preferably located in the wire layer w1 closest to the device layer 01. As can be seen, deep trench isolations 13a, 13b are provided in the device layer 01 below the contact zones 12, for reasons that will be explained further.

While only two magnetic sensor elements M1, M2 are shown to keep the drawings simple, the device layer 01 may comprise doped or implanted semiconductor structures that have a features size less than or equal to 200 nm, e.g. less than or equal to 180 nm, or e.g. less than or equal to 110 nm made with photolithographic method and materials, and can be a digital circuit, such as a CMOS circuit, a mixed-signal circuit, or an analog circuit.

It is pointed out that the drawings are not drawn to scale for illustrative purposes. This applies especially to the thicknesses of the various layers. Indeed,
- the device layer 01 may have a thickness in the range from about 0.3 µm to about 100 µm, but in the context of the present invention preferably has a thickness from 1.0 to 10.0 µm;
- the buried oxide layer 03 may have a thickness from 0.1 µm to about 3.0 µm, and in the context of the present invention preferably has a thickness from 0.5 to 1.5 µm;
- the bulk silicon layer 02 may have an original thickness in the range from about 500 µm to about 1000 µm, and in the context of the present invention preferably has an original thickness from about 700 to about 750 µm, which is thinned to a thickness smaller than 100 µm, or smaller than 25 µm, or smaller than 5 µm, or smaller than 1.0 µm, or even completely removed.

**FIG. 4** shows the semiconductor wafer of FIG. 3 after providing and patterning a polyimide layer 21 in optional step p), and after depositing at least one magnetic concentrator 31, 31' in step c) using known techniques for depositing magnetic concentrator material on top of an interconnection stack, e.g. by using electroplating, sputtering, spraying, or pick & place, or combinations hereof.

In particular embodiments, the at least one magnetic concentrator 31 is not located on top of the interconnection stack 10, but may be partially or completely implemented in the interconnection stack 10, for example using method steps described in patent application EP3742182(A1), or using method steps described in patent application EP24174812.8 filed on 08 May 2024, both documents being incorporated herein by reference in their entirety. This offers the advantage that the distance between the at least one magnetic concentrator 31 and the magnetic sensor element can be further reduced, which will further increase the sensitivity, and further improve SNR, and further reduce e.g. a measurement error, e.g. a linear or angular position error.

The at least one magnetic concentrator 31 can have a predefined shape and thickness, see e.g. the example of FIG. 10, where the IMC at the front side has a circular shape, and the IMC's at the back side have a trapezoidal shape, or vice versa, but the present invention is not limited hereto, and other shapes can also be used. However, the shape(s) and size(s) and relative position(s) of the magnetic sensor element(s) are not the main focus of the present invention, and hence will not described in more detail here.

**FIG. 5** shows the semiconductor wafer of FIG. 4 after mounting a carrier wafer 41 to the front side of the semiconductor wafer in step m).

The carrier wafer 41 may be connected to the SOI-wafer using a bonding technique such as e.g. glass frit bonding. The carrier wafer 41 may e.g. be a glass wafer or a silicon wafer. The carrier wafer 41 may be a cavity wafer having a plurality of cavities 43 or recesses for accommodating the magnetic concentrators 31, 31'. In the example of FIG. 5, the cavity wafer 41 has two cavities 43, 43' for accommodating two magnetic concentrators 31, 31', but that is not absolutely required, and it is also possible to provide a cavity wafer having a single cavity for each die area, without a support in between).

It is noted that the carrier wafer 41 does not need to be a cavity wafer, but a flat carrier wafer (not shown) could be used instead. In this case, a passivation layer (e.g. comprising polyimide and/or a dielectric) may be deposited over the entire front side of the semiconductor wafer of FIG. 4, thus also on top of the magnetic concentrator(s), then the surface would be planarized (made flat), and then the flat carrier wafer would be mounted to the semiconductor substrate, e.g. using screen printing, or using an adhesive, or the like. Instead of using a flat carrier wafer, it is also possible to use a carrier wafer with a relatively thick passivation layer, and to pattern this passivation layer to create cavities before bonding the carrier wafer to the semiconductor wafer.

**FIG. 6** shows the semiconductor wafer of FIG. 5 after thinning the backside of the semiconductor wafer in step b), and after exposing at least some of the contact areas 12 in step x), and after providing and patterning a polyimide layer and/or a nitride layer 22 at the thinned back side in step q). As mentioned above, step q) is not mandatory.

The thinning in step b) may comprise grinding and/or etching.

The contact areas 12 can e.g. be exposed by etching an opening in the buried oxide layer 03 at a location between the holes or trenches with isolating material (e.g. DTI-sidewalls 13a, 13b), and by etching the material 14 located between the isolating sidewalls 13a, 13b, preferably using the contact area 12 as an etch stop.

**FIG. 7** shows the semiconductor wafer of FIG. 6 after deposition of an electrically conductive seed-layer 23 (e.g. for allowing electroplating), and after plating the contact areas 12 (e.g. with Cu and/or Au) using a first mask. Instead of using a combination of depositing a seed-layer and copper plating, one could also use aluminium patterning. These steps are known per sé in the art, and hence need not be explained in more detail here.

**FIG. 8** shows the semiconductor wafer of FIG. 7 after forming the magnetic concentrator 32 using electroplating, using a second mask to expose the area where the magnetic concentrator 32 is to be deposited or grown; and after etching the seed-layer 23 to electrically disconnect the contact areas 12.

It is noted, however, that plating of the contact areas 12 (e.g. with Cu and/or Au) is not absolutely required, and may be omitted, or be replaced by deposition and patterning of an aluminium layer.

**FIG. 9** shows an alternative for FIG. 7 and FIG. 8, and shows a semiconductor wafer that can be obtained from the semiconductor wafer of FIG. 6 after providing a seed-layer 23, and after forming the magnetic concentrator 32 using electroplating, using a mask to expose the area where the magnetic concentrator 32 is to be deposited or grown, and after etching the seed-layer 23 to electrically disconnect the contact areas 12.

As will be appreciated by the skilled person, FIG. 8 and FIG. 9 only show a portion of the semiconductor wafer, e.g. showing a single die area in cross section. The semiconductor wafers 800, 900 can then be diced into a plurality of semiconductor dies, as schematically indicated by scissors.

These dies can then be mounted on a lead frame, and the leads of the lead frame may be connected to the contact areas 12 by wire bonding (not shown). A plastic or a ceramic moulding compound can then be applied, yielding an integrated circuit (or "chip") in a plastic or a ceramic package.

**FIG. 10** shows an illustrative example of a possible shape for the at least one IMC located at the front side of the semiconductor wafer or "front IMC(s)", and for the at least one IMC located at the back side of the semiconductor wafer, or "back IMC(s)".

As explained above, the one or more "front IMC" is located at a higher Z-position than the corresponding magnetic sensor element, and the one or more "back IMC" is located at a smaller Z-position than the corresponding magnetic sensor element.

In the example shown in FIG. 10, there is a single "front IMC", namely IMC1, and there are four "back IMC's", namely IMC2a, IMC2b, IMC2c, IMC2d. The back IMCs are located in a plane having a Z-coordinate smaller than that of the magnetic sensor, and the magnetic sensor is located in a plane having a Z-coordinate smaller than that of the front IMC.

Depending on the type of magnetic sensor element(s), orthogonal projections of the at least one front IMC and the at least one back IMC may overlap, or may be spaced apart from each other, and the orthogonal projection(s) of the magnetic sensor element(s) M1, M2, M3, M4 may or may not fall inside the region of overlap (if any), or between the regions of overlap. For example, in case of horizontal Hall elements, preferably the front IMC(s) and the back IMC(s) have an overlapping zone, and an orthogonal projection of the magnetic sensor element is preferably completely located inside this overlapping zone, or at least partially inside this overlapping zone. In case of vertical Hall elements or magneto-resistive (MR) elements, (not shown), it may be advantageous that orthogonal projections of the front IMC(s) and the back IMC(s) do not overlap, and that orthogonal projections of the one or more magnetic sensor elements are located between the projection(s) of the front IMC(s) and projection(s) of the back IMC(s).

In the specific example shown in FIG. 10, the semiconductor wafer has four horizontal Hall elements M1, M2, M3, M4, has a single "front IMC" IMC1 above the device layer, and four "back IMCs" IMC2a, IMC2b, IMC2c, IMC2d located on the thinned back side of the semiconductor wafer. As can be seen, the front IMC of this example has a circular disk shape, and the back IMCs have a trapezoidal shape, but of course, the present invention is not limited hereto, and other shapes and/or orientations may also be used.

In a variant, a single circular disk is located on the back side of the semiconductor surface, and four trapezoidal shapes are located on the front side of the semiconductor surface. This is not preferred, however, because the cavity wafer may be more complex, and also the mounting of the cavity wafer to the front side of the semiconductor wafer may be more complex.

The one or more magnetic concentrator(s) located at the front side preferably has/have a first constant thickness T1, and the one or more magnetic concentrator(s) located on the back side preferably has/have a second constant thickness T2. The second thickness T2 may be larger than T1, smaller than T1, or substantially equal to T1 within a predefined tolerance margin (e.g. within ±10%, or ±5%, or ±3%, or ±2%).

If the one or more front IMC is located outside of the interconnection stack 10, it may preferably have a thickness in the range from 5 µm to 35 µm, e.g. equal to about 22 µm. If the one or more front IMC is at least partially located inside the interconnection stack, it may have a thickness in the range from about 10 µm to 25 µm, e.g. equal to about 15 µm. It is noted that the front IMC and the back IMC may have different thicknesses. For example, if the front IMC has a larger size than the back IMC, the thickness of the front IMC may be larger than that of the back IMC to obtain a higher saturation.

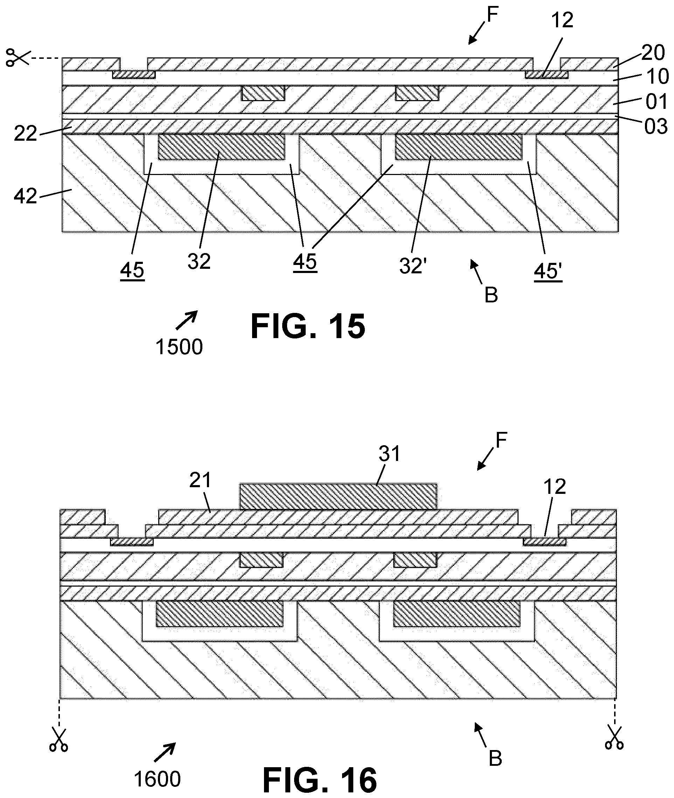

**FIG. 11** shows a flow-chart of a method 1100 for producing a semiconductor substrate, e.g. the semiconductor wafer/die 1600 shown in FIG. 16 before/after dicing the semiconductor wafer and the carrier wafer. The method 1100 of FIG. 11 can be seen as another special case of the method 100 of FIG. 1, and/or as a variant of the method 200 of FIG. 2.

The method 1100 comprises the following steps:
a) providing 1101 a semiconductor wafer comprising: a front side or device layer 01 comprising at least one magnetic sensor element, and a back side or bulk layer 02; an interconnection stack 10 situated on top of the device layer 01, and comprising a plurality of contact areas 12. The semiconductor wafer may also comprise a passivation layer 20 on top of the interconnection stack 10. The contact areas 12 may be exposed.
   An example of such a semiconductor wafer 1200 is illustrated in FIG. 12. The wafer may be a silicon-on-insulator (SOI) wafer, but that is not absolutely required. In the example of FIG. 12, the device layer 01 comprises two magnetic sensor elements M1, M2, e.g. two horizontal Hall elements, but of course the device layer may comprise many more active or passive components or electronic circuits. In the example of FIG. 12, the wafer 1200 has a passivation layer 20 and the contact areas 12 are already exposed. If the contact areas 12 would not be exposed, they may be exposed in step x), following step a), or at a later stage.
x) optionally exposing 1102 at least some of the contact areas 12,
   for example by making an opening in the passivation layer 20 using a mask, and by etching, using the contact area 12 as an etch stop. In the method of FIG. 11, the contact area 12 is preferably located in wire layer w4, distal from the device layer 01, but that is not absolutely required, and another wire layer could also be used, for example w3.
m) mounting (e.g. temporarily bonding) 1103 a first carrier wafer 41 to the front side of the semiconductor wafer;
b) thinning 1104 the back side of the semiconductor wafer;
   For example by grinding, back-grinding and/or etching. If an SOI wafer is used, the wafer is preferably thinned to the buried oxide layer 03. An example of a semiconductor wafer derived from the semiconductor wafer 1200 of FIG. 12 after performing optional step x), step m) and step b) is illustrated in FIG. 13.
q) optionally providing 1105 a polyimide layer 22 to the thinned back side of the semiconductor wafer, and optionally patterning this polyimide layer 22 using lithography;
d) providing (e.g. depositing) 1106 at least one magnetic concentrator 32, 32' on or to the thinned back side of the semiconductor wafer, e.g. on top of said polyimide layer (if present);
   For example by electroplating, sputtering, or combinations hereof.
   An example of a semiconductor wafer derived from the semiconductor wafer of FIG. 13 after performing steps q) and d) is illustrated in FIG. 14. In this example two back IMCs are provided, but that is not required, and a single back IMC or more than two back IMCs are also possible.
i) mounting 1107 a second carrier wafer 42 to the thinned back side of the semiconductor wafer; The second carrier wafer 42 may be permanently bonded, using e.g. a glass frit bond. The second carrier wafer 42 may be a cavity wafer, but that is not absolutely required.
j) removing 1108 the first carrier wafer 41 from the front side of the semiconductor wafer;
   The removal of step j) is schematically indicated by scissors.
   An example of a semiconductor wafer derived from the semiconductor wafer of FIG. 14 after performing steps i) and j) is illustrated in FIG. 15.
   In the example shown in FIG. 15, the second carrier wafer 42 is a cavity wafer having two cavities 45, 45' for accommodating the magnetic concentrators 32, 32'. In a variant (not shown) a cavity wafer having only one cavity 45 per die area is used.
      It is noted, however, that the second carrier wafer 42 does not need to be a cavity wafer, and a flat carrier wafer could be used instead. In this case, a passivation layer (e.g. comprising polyimide and/or a dielectric material), may be deposited on or to the back side of the semiconductor wafer of FIG. 14 (and on top of the back IMC), and the surface could then be planarized (made flat), and then a flat carrier wafer could be mounted, e.g. using screen printing, or using an adhesive, or the like. For example, as already mentioned above, the carrier wafer may be laminated with an organic layer (such as e.g. polyimide) and patterned as a resist with photolithography.
p) optionally providing 1109 a polyimide layer 21 to the front side of the semiconductor wafer, and optionally patterning this polyimide layer using lithographical techniques.
c) providing (e.g. depositing) 1110 at least one magnetic concentrator 31 on or to the front side of the semiconductor wafer;
   The at least one magnetic concentrator 31 may for example be deposited by electroplating, sputtering, or combinations hereof.
   An example of a semiconductor wafer derived from the semiconductor wafer of FIG. 15 after performing optional step p) and step c) is illustrated in FIG. 16.

The method 1100 may optionally further comprise one or more of the following steps:
e) dicing 1111 the semiconductor wafer and the second carrier wafer, to provide a plurality of semiconductor dies;
f) electrically connecting 1112 the contact areas 12 to bond wires (not explicitly shown), e.g. for electrically connecting the contacting areas to elongated leads of a lead-frame;
g) packaging 1113 the semiconductor dies, e.g. in plastic or ceramic packages, e.g. by providing a moulding compound.

**FIG. 12 to FIG. 16** show cross-sections of intermediate semiconductor wafers as can be obtained by performing some or all of the steps of the method of FIG. 11.

**FIG. 12** shows a semiconductor wafer 1200 as may be provided in step 1101 of FIG. 11. The semiconductor wafer 1200 of FIG. 12 is preferably an SOI-wafer comprising a Buried Oxide Layer 03 separating an upper silicon layer (also referred to as "device layer" 01), and a lower silicon layer (also referred to as "bulk silicon layer" 02). The arrow "F" points to the "front side" of the semiconductor wafer. The arrow "B" points to "back side" of the semiconductor wafer.

When comparing FIG. 12 and FIG. 3, it can be seen that the semiconductor substrate 1200 of FIG. 12 does not need to have holes or trenches with isolating sidewalls e.g. Deep Trench Isolations (DTI), and that the contact areas 12 are preferably located in a wire layer (e.g. w4 or w3) distal from the magnetic sensor element(s). Everything else described for FIG. 3 is also applicable here, mutatis mutandis.

In the example of FIG. 12, the semiconductor wafer 1200 has a passivation layer 20, and the contact areas 12 are already exposed in step 1101, but if they are not yet exposed, they can be exposed in step 1102.

**FIG. 13** shows the semiconductor wafer of FIG. 12 (turned upside down), after mounting (in step 1103) a first carrier wafer 41 to the front side of the semiconductor wafer (for providing mechanical support), and after thinning (in step 1104) the back side of the semiconductor wafer. In the example shown, the wafer is thinned to the buried oxide layer 03, and the bulk silicon layer 02 is completely removed.

**FIG. 14** shows the semiconductor wafer of FIG. 13 after providing and patterning (in step 1105) an optional polyimide layer 22 on the thinned back side of the semiconductor wafer, which in this example means on the buried oxide layer 03; and after depositing (in step 1106) one or more magnetic concentrator 32, 32' using known techniques, e.g. electroplating, sputtering, or combinations hereof.

**FIG. 15** shows the semiconductor wafer of FIG. 14 (turned upside down), after permanently mounting (in step 1107) a second carrier wafer 42 to the thinned back side of the semiconductor wafer, and after removing (in step 1108) the first carrier wafer 41 from the front side.

In the example shown in FIG. 15, the second carrier wafer 42 is a cavity wafer, but as explained above (FIG. 5), that is not absolutely required, and a flat carrier wafer could be used instead. In that case, a passivation layer, e.g. comprising polyimide and/or a dielectric material, may be deposited on the back side of the semiconductor wafer of FIG. 14 (and on top of the IMC's 32, 32'), and the back surface may be planarized (made flat), so that a flat carrier wafer can be mounted, e.g. using screen printing, or using an adhesive, or the like.

**FIG. 16** shows the semiconductor wafer of FIG. 15 after providing and patterning (in step 1109) a polyimide layer 21 to the front side of the semiconductor wafer, and after depositing (in step 1110) one or more magnetic concentrator 31, using known techniques.

As will be appreciated by the skilled person, FIG. 16 shows only a portion of the semiconductor wafer, e.g. showing only a single die area in cross section. The semiconductor wafer 1600 can then be diced (in step 1111) into a plurality of semiconductor dies, as schematically indicated by scissors.

These dies may then be mounted on a lead frame, and the leads of the lead frame may be connected (in step 1112) to the contact areas 12 by wire bonding. A plastic or a ceramic moulding compound can then be applied (in step 1113), yielding an integrated circuit in a plastic or ceramic package.

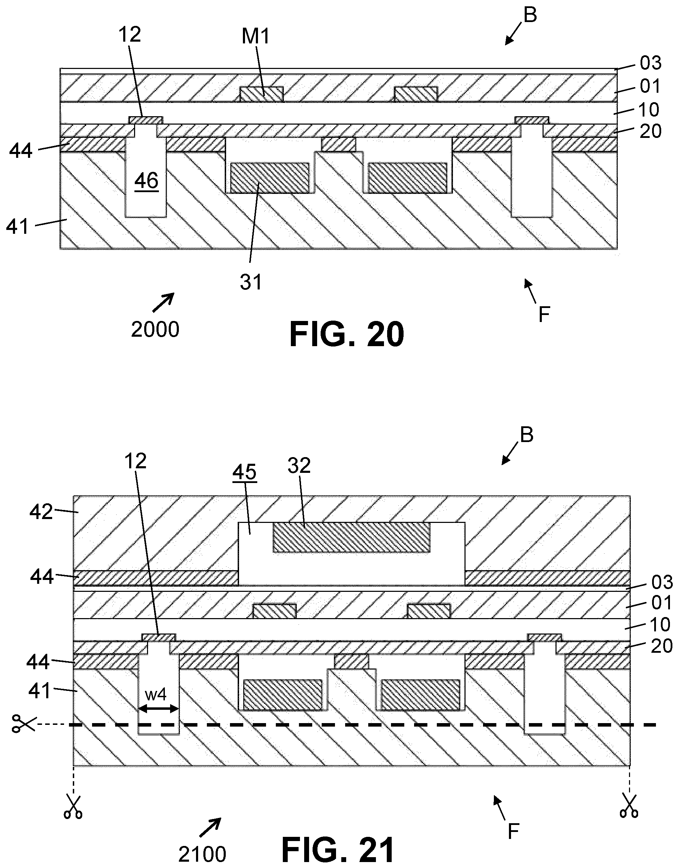

**FIG. 17** shows a flow-chart of a method 1700 for producing a semiconductor substrate, e.g. the semiconductor wafer/die 2100 shown in FIG. 21 before/after dicing the semiconductor wafer and the carrier wafer. The method 1700 of FIG. 17 can be seen as another special case of the method 100 of FIG. 1, and/or as a variant of the method 200 of FIG. 2, and/or as a variant of the method 1100 of FIG. 11.

The method 1700 has the following steps:
a) providing 1701 a semiconductor wafer comprising: a front side or device layer 01 comprising at least one magnetic sensor element, and a back side or bulk layer 02; an interconnection stack 10 situated on top of the device layer 01, and comprising a plurality of contact areas 12. The semiconductor wafer may also comprise a passivation layer 20 on top of the interconnection stack 10. The contact areas 12 may be exposed.
   Step 1701 may be identical to step 1101 of FIG. 11. An example of such a semiconductor wafer 1800 is illustrated in FIG. 18. If the contact areas 12 are not yet exposed, they can be exposed in a later step x). The semiconductor wafer may be an SOI-wafer, and the device layer 03 may contain other electrical components and/or circuits, e.g. provided using a CMOS process.
x) optionally exposing 1702 at least some of the contact areas 12, for example by making an opening in the passivation layer 20 in the vicinity of the contact area 12, and by etching some of the dielectric material of the interconnection stack, preferably using the contact area 12 as an etch stop.
m), c) mounting 1703 a first carrier wafer 41 comprising a plurality of cavities or recesses 43 containing at least one magnetic concentrator 31 to the front side of the semiconductor wafer.
   The mounting may be performed by glass frit bonding. An example of a semiconductor wafer 1900 derived from the semiconductor wafer 1800 of FIG. 18 after performing step m), c) is illustrated in FIG. 19. The first carrier wafer 41 preferably also comprises deep cavities or grooves 46 having a depth (or height) T4 larger than the depth (or height) T3 of the cavities or recesses 43 that contain the at least one magnetic concentrator 31.
b) thinning 1704 the back side of the semiconductor wafer;
   For example by grinding, back-grinding and/or etching. If an SOI wafer is used, the wafer is preferably thinned to the buried oxide layer. An example of a semiconductor wafer derived from the semiconductor wafer 1900 of FIG. 19 after performing step b), (turned upside down) is illustrated in FIG. 20.
m), d) mounting 1705 a second carrier wafer 42 comprising a plurality of cavities or recesses 45 containing at least one magnetic concentrator 32 to the thinned back side of the semiconductor wafer;
   The mounting may be performed by glass frit bonding. An example of a semiconductor wafer derived from the semiconductor wafer 2000 of FIG. 20 after performing step m), d) is illustrated in FIG. 21.

The method 1700 may optionally further comprise one or more of the following steps:
e) dicing 1706 the semiconductor wafer and the carrier wafers, to provide a plurality of semiconductor dies;
f) electrically connecting 1707 the contact areas 12 to bond wires, e.g. for electrically connecting the contacting areas to elongated leads of a lead-frame;
g) packaging the semiconductor dies, e.g. in plastic or ceramic packages.

**FIG. 18 to FIG. 22** show cross-sections of intermediate semiconductor wafers, as can be obtained by performing some or all of the steps of the method of FIG. 17.

**FIG. 18** shows a semiconductor wafer 1800 as may be provided in step 1701 of FIG. 17, or after performing step 1702 if the contact areas 12 were not exposed yet. The semiconductor wafer 1800 of FIG. 18 is preferably an SOI-wafer comprising a device layer 01, and a buried oxide layer 03, and a bulk layer 02. The arrow "F" points to the "front side" of the semiconductor wafer. The arrow "B" points to the "back side" of the semiconductor wafer. The semiconductor wafer 1800 of FIG. 18 may be identical to the wafer 1200 of FIG. 12, and everything described for wafer 1200 is also applicable here, for example, the contact areas 12 are preferably located in a wire layer distal from the device layer 01, e.g. in w4, although that is not absolutely required.

**FIG. 19** shows a semiconductor wafer 1900 as can be derived from the semiconductor wafer 1800 of FIG. 18, after mounting (in step 1703) a first carrier wafer 41 to the front side of the semiconductor wafer. The first carrier wafer 41 comprises a first plurality of cavities or recesses 43 having a first depth T3, and comprises a second plurality of cavities or recesses or grooves 46 having a second depth T4 larger than the first depth T3. There is at least one magnetic concentrator 31 situated in the first plurality of cavities 43.

By taking into account the depth T3 of the first cavities, the height (or thickness) T1 of the IMC 31, and the thickness T5 of the bond layer 44 (e.g. about 1.0 to about 10 µm for a glass frit, an adhesive or a metallic bond), the distance between the passivation layer 20 and the IMC surface 31 can be defined. Or stated in other words, the distance "g" between the passivation layer 20 and the magnetic concentrator 31 can be defined by choosing appropriate values for T1, T3 and T5.

It is noted that T1 and T3 can be made substantially the same (e.g. within a predefined tolerance margin of ±5%) by applying CMP (chemical mechanical polishing) after plating of the cavity wafer, where the IMC initially sticks out of the cavity wafer by a predefined amount (e.g. a few µm)

Step 1703 corresponds to the combination of step m) (mounting carrier wafer) and step c) (arranging a magnetic concentrator to or at the front side of the wafer) of FIG. 1, hence the label "m, c".

In preferred embodiments, the height (or thickness) T1 of the at least one magnetic concentrator 31 is chosen approximately 10 µm larger than the depth T3 of the cavity 43, such that, when the glass frit 44 is applied, and the carrier wafer 41 is pressed to the semiconductor wafer at a temperature of about 430°C, the magnetic concentrator 31 will initially contact the semiconductor wafer, but after cooling down, the magnetic concentrator material (e.g. NiFe) will shrink more than the glass frit layer 44, such that a small gap "g" of about 100 nm will be formed between the passivation layer 20 and the magnetic concentrator 31.

While not explicitly shown, there may be a stress reduction layer, e.g. a polyimide layer applied between the carrier wafer 41 and the magnetic concentrator 31.

**FIG. 20** shows a semiconductor wafer 2000 as can be derived from the semiconductor wafer 1900 of FIG. 19, after thinning (in step 1704) the back side of the semiconductor wafer as schematically indicated by scissors in FIG. 19. In the example shown, the back side of the semiconductor wafer is thinned to the buried oxide layer 03, and the bulk silicon layer 02 is completely removed.

**FIG. 21** shows a semiconductor wafer 2100 as can be derived from the semiconductor wafer 2000 of FIG. 20, after mounting (in step 1705) a second carrier wafer 42 to the back side of the semiconductor wafer. The second carrier wafer 42 comprises a plurality of cavities or recesses 45, comprising at least one magnetic concentrator 32. Step 1705 corresponds to the combination of step m) and step d) of FIG. 1.

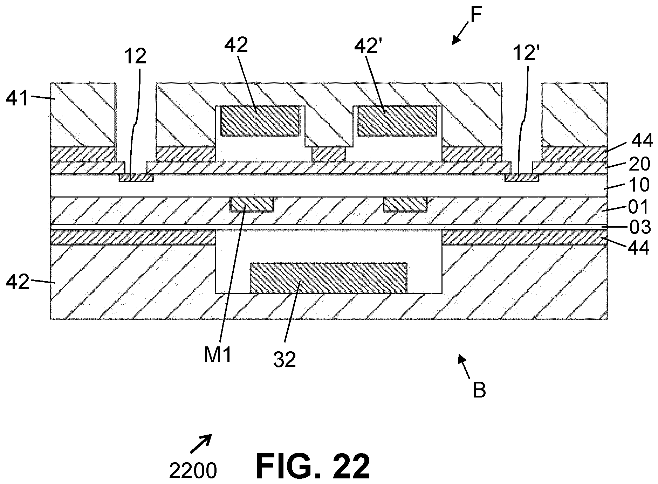

**FIG. 22** shows a semiconductor wafer 2200 as can be derived from the semiconductor wafer 2100 of FIG. 21, after back-grinding and/or etching the first cavity wafer 41 so as to expose the contact areas 12, so they can be used as bondpads. By choosing an appropriate width w4 of the "deep cavities or grooves" 46 of the first carrier wafer 41, the contact areas 12 can be made easily accessible for wire bonding.

Above several examples of methods of producing a semiconductor wafer with a front IMC and a back IMC are described, but of course, the present invention is not limited to these specific examples, and combinations of steps obtained from the different methods shown in FIG. 2, FIG. 11 and FIG. 17 are also contemplated.

### References:

- -00: semiconductor substrate (e.g. semiconductor wafer or semiconductor die)
- -01: device layer (located on the front side of the semiconductor wafer)
- -02: back side of the semiconductor wafer
- -03: buried oxide layer
- -10: interconnection stack
- -12: contact area / "bond pad"
- -13: holes or trenches with isolating sidewalls, e.g. deep trench isolation (DTI)
- -14: a portion of silicon located between isolating sidewalls (e.g. DTI)
- -15: contact plating (e.g. Cu and/or Au)
- -20: passivation layer
- -21: polyimide at the front
- -22: polyimide at the back
- -23: seed-layer
- -31: Magnetic Flux Concentrator (IMC) at the front side, or "front IMC"
- -32: Magnetic Flux Concentrator (IMC) at the back side, or "back IMC"
- -41: first carrier wafer (e.g. cavity wafer)
- -42: second carrier wafer (e.g. cavity wafer)
- -43: cavity or recess in first carrier wafer
- -44: wafer bond (e.g. glass frit)
- -45: cavity or recess in second carrier wafer
- -46: deep cavities or grooves (for facilitating dicing)
- M1, M2: first, second magnetic sensor element
- w1: wires of first metal layer / "first metallization layer" (proximal to the device layer)
- w4: wires of fourth metal layer/ "fourth metallization layer" (distal to the device layer)
- F: front side of the semiconductor wafer
- B: back side of the semiconductor wafer
- T1: thickness of front IMC(s)
- T2: thickness of back IMC(s)
- T3: depth of first cavities
- T4: depth of second cavities
- T5: thickness of glass frit layer
- g: distance between passivation layer 20 and front IMC

## Claims

1. A method (100; 200; 1100; 1700) of producing a semiconductor substrate, comprising the following steps:
a) providing (101) a semiconductor wafer comprising: a front side or a device layer (01) and a back side, and an interconnection stack (10) situated on top of the device layer (01), wherein the device layer comprises at least one embedded magnetic sensor element (M1), and wherein the interconnection stack (10) comprises a plurality of contact areas (12);
m) mounting (102) a carrier wafer to the front side of the semiconductor wafer;
b) thinning (103) the back side of the semiconductor wafer;
c) providing at least one magnetic concentrator on or to the front side of the semiconductor wafer;
d) providing at least one magnetic concentrator on or to the thinned back side of the semiconductor wafer;
wherein step m) is performed before step b) to provide mechanical support such that the wafer can be further processed without being damaged.

2. A method (100; 200; 1100; 1700) according to claim 1, further comprising one or more of the following steps:
x) exposing (104) at least some of the contact areas (12);
e) dicing (107) the semiconductor wafer and the carrier wafer, to provide a plurality of semiconductor dies;
f) electrically connecting (108) the contact areas to wire bonds;
g) packaging (109) the semiconductor dies.

3. A method (100; 200; 1100; 1700) according to any of the previous claims,
wherein step a) comprises: providing a silicon-on-insulator (SOI) wafer comprising a device layer comprising silicon, and a bulk layer (02) comprising silicon, and further comprising a buried-oxide located between the device layer and the bulk layer;
and wherein step b) comprises: reducing a thickness of the bulk layer by removing at least 40%, or at least 50% or at least 60% or at least 70% or at least 80% or at least 90% of the silicon layer on the back-side of the SOI-wafer, or completely removing the bulk layer by etching the silicon at the back side using the buried oxide layer as an etch stop.

4. A method (200; 1100) according to any of the previous claims,
further comprising at least one of the following steps:
p) providing (202; 1109) a stress-reduction layer (22) on or to the front side of the semiconductor wafer before performing step c);
q) providing (207; 1105) a stress-reduction layer (22) to the thinned back side of the semiconductor wafer before performing step d).

5. A method (200) according to any of the claims 1 to 4,
wherein step c) is performed before step b);
wherein step c) comprises: depositing (203) at least one layer of ferromagnetic material (31, 31') on or to the front side of the semiconductor wafer;
wherein step d) comprises: depositing (208) at least one layer of ferromagnetic material (32, 32') to the thinned back side of the semiconductor wafer.

6. A method (1100) according to any of the claims 1 to 4,
wherein step d) is performed before step c);
and wherein step m) is performed before step b), and comprises: mounting (1103) a first carrier wafer (41) to the front side of the semiconductor wafer;
and wherein the method further comprises step i), after step d), of mounting (1107) a second carrier wafer (42) to the thinned back side of the semiconductor wafer;
and wherein the method further comprises step j), before step c), of removing (1108) the first carrier wafer (41) mounted to the front side of the semiconductor wafer.

7. A method (1700) according to any of the claims 1 to 4,
wherein step c) is performed before step b);
and wherein step c) comprises: mounting (1703) a first cavity wafer (41) comprising at least one magnetic concentrator (31) to the front side of the semiconductor wafer;
and wherein step d) comprises: mounting (1705) a second cavity wafer (42) comprising at least one magnetic concentrator (32) to the thinned back side of the semiconductor wafer.

8. A method (1700) according to claim 7,
wherein step c) comprises: providing the first carrier wafer (41) having a first plurality of recesses or cavities (42) having a first depth (T3) for accommodating said at least one IMC (31), and having a second plurality of recesses or cavities or grooves (46) having a second depth (T4) larger than the first depth (T3);
and wherein the method further comprises a step of reducing a thickness of the first carrier wafer (41) for opening the second plurality of recesses or cavities or grooves (46) thereby exposing the at least one contact area (12).

9. A method (100; 200; 1100; 1700) according to any of the previous claims,
wherein the at least one magnetic concentrator (31) provided in step c) has a circular disk shape, and the at least one magnetic concentrator (32) provided in step d) has an elongated shape, or vice versa;
or wherein the at least one magnetic concentrator (31) provided in step c) has a circular disk shape, and the at least one magnetic concentrator (32) provided in step d) also has a circular disk shape.

10. A method (100; 200; 1100; 1700) according to any of the previous claims,
wherein the at least one magnetic sensor element is a horizontal Hall element, and wherein an orthogonal projection of the magnetic sensor element and an orthogonal projection of the at least one magnetic concentrator (31) provided at the front side, and an orthogonal projection of the at least one magnetic concentrator (32) provided at the back side, at least partially overlap;
or wherein the at least one magnetic sensor element is a vertical Hall element or a magneto-resistive element, and wherein an orthogonal projection of the magnetic sensor element is located between an orthogonal projection of the at least one magnetic concentrator (31) provided at the front side, and an orthogonal projection of the at least one magnetic concentrator (32) provided at the back side.

11. A method according to any of the previous claims,
wherein a distance between the at least one front **IMC** and the at least one back **IMC** measured in a direction perpendicular to the semiconductor substrate is smaller than 200 µm, or smaller than 50 µm.

12. A method according to any of the previous claims,
wherein step m) comprises: mounting a carrier wafer comprising a plurality of cavities;
or wherein step m) comprises: mounting a carrier wafer that is planar without any cavities.

13. A magnetic sensor device comprising:
- a semiconductor substrate comprising: a front side or a device layer (01) and a back side, and an interconnection stack (10) situated on top of the device layer (01), wherein the device layer comprises at least one embedded magnetic sensor element (M1), and wherein the interconnection stack (10) comprises a plurality of contact areas (12);
- at least one magnetic concentrator on or to the front side of the semiconductor substrate;
- at least one magnetic concentrator on or to the back side of the semiconductor substrate.

14. A magnetic sensor device according to claim 13, further comprising one or more of the following features:
- wherein a distance (Δz) between the at least one magnetic concentrator at the front side and the at least one magnetic concentrator at the back side, measured in a direction (Z) perpendicular to the semiconductor substrate, is smaller than 200 µm;
- wherein the at least one magnetic concentrator at the front side and the at least one magnetic concentrator at the back side have a planar shape;
- wherein orthogonal projections of the at least one magnetic concentrator at the front side, and the at least one magnetic concentrator at the back side, and the at least one magnetic sensor element (M1) onto the semiconductor substrate at least partially overlap;
- wherein the semiconductor substrate further comprises a passivation layer;
- wherein the semiconductor substrate further comprises a dielectric layer at the back side, e.g. an oxide layer;
- wherein the semiconductor substrate further comprises a polyimide layer situated between the semiconductor substrate and the at least one magnetic concentrator at the front side;
- wherein the semiconductor substrate further comprises a polyimide layer situated between the semiconductor substrate and the at least one magnetic concentrator at the back side;
- wherein the sensor device further comprises a carrier substrate mounted to the semiconductor substrate such that the at least one magnetic concentrator at the front side is located between the semiconductor substrate and the carrier substrate, the carrier substrate optionally having at least one cavity or optionally being planar without any cavity;
- wherein the sensor device further comprises a carrier substrate mounted to the semiconductor substrate such that the at least one magnetic concentrator at the back side is located between the semiconductor substrate and the carrier substrate, the carrier substrate optionally having at least one cavity or optionally being planar without any cavity;
- wherein the at least one magnetic sensor element is at least one horizontal Hall element or at least one vertical Hall element;
- wherein the magnetic sensor device further comprises one or more of the following: a biasing and readout circuit, an amplifier, an analog-to-digital convertor, a digital processor, a temperature sensor, a non-volatile memory;
- wherein the magnetic sensor device is a current sensor device;
- wherein the magnetic sensor device is a linear position sensor device;
- wherein the magnetic sensor device is an angular position sensor device;
- wherein the magnetic sensor device is a proximity sensor device;
- wherein the magnetic sensor device is a pressure sensor device;
- wherein the magnetic sensor device is a force sensor device;
- wherein the magnetic sensor device is a torque sensor device;
- wherein the magnetic sensor device is a force sensor device;
- wherein the magnetic sensor device is a speed sensor device;
- wherein the magnetic sensor device is an electronic compass.

15. A magnetic sensor device according to claim 13 or 14,
further comprising a processing circuit connected to said at least one magnetic sensor element, wherein the processing circuit is configured for determining one of the following: a current value, one or more angular position values, one or more linear position values, a proximity value, one or more pressure values, one or more force values, a torque value, a speed value, an acceleration value.
